# EUROPEAN PATENT APPLICATION

(11) **EP 4 793 987 A1**
(43) Date of publication of application: **19.08.2026**
(21) Application number: 24877099.2
(22) Date of filing: 03.10.2024
(51) Int. Cl.: H01L 21/02, G01R 31/26, H01L 21/66

(54) **TEMPERATURE CONTROL STAGE AND INSPECTION DEVICE**

(30) Priority: 13.10.2023 JP 2023177700
(71) Applicant: Tokyo Electron Limited, Tokyo 107-6325 (JP); Tomoegawa Corporation, Tokyo 104-8335 (JP)
(72) Inventor: KOBAYASHI, Dai, Nirasaki City, Yamanashi 4078511 (JP); NAKAYAMA, Hiroyuki, Nirasaki City, Yamanashi 4078511 (JP); MORIUCHI, Hideki, Shizuoka-city, Shizuoka 421-0192 (JP); HATANO, Syuuhei, Shizuoka-city, Shizuoka 421-0192 (JP)
(74) Representative: Hoffmann Eitle
(86) International application number: PCT/JP2024/035499
(87) International publication number: WO 2025/079503

(57) **Abstract**

A temperature control stage includes: a top plate configured for a processing target to be mounted on a surface of the top plate; a heating part disposed on a back surface of the top plate or inside the top plate; a heat exchanger disposed adjacent to the top plate or the heating part, and including, in an interior of the heat exchanger, a circulation space in which a gas circulates; and a gas supply configured to supply the gas to the circulation space. The heat exchanger includes: a projection group region including a plurality of projections composed of metal fiber and projecting in the circulation space, thereby promoting heat exchange with the gas; and a non-installation region free of the plurality of projections, thereby causing less heat exchange with the gas than in the projection group region.

## Description

### TECHNICAL FIELD

The present disclosure relates to a temperature control stage and an inspection device.

### BACKGROUND ART

An inspection device includes a tester for electrically inspecting a substrate, which is a processing target. In the electrical inspection, the substrate generates heat due to power being supplied from the tester. If the amount of heat generated by the substrate is large, the temperature of the substrate is likely to exceed the target temperature during the inspection.

In order to lower the temperature of the substrate in such an inspection, PTL 1 discloses an inspection device including a cooling channel provided in a substrate mounting table (temperature control stage) and a chiller unit for circulating a refrigerant in the cooling channel.

### CITATION LIST

### PATENT LITERATURE

PTL 1: Japanese Patent Application Laid-Open Publication No. 2021-128965

### SUMMARY OF THE INVENTION

### TECHNICAL PROBLEM

The present disclosure provides a technique capable of efficiently controlling the temperature of a processing target and promoting uniformization of the in-plane temperature distribution in the processing target.

### SOLUTION TO THE PROBLEM

According to one embodiment of the present disclosure, a temperature control stage is provided, including: a top plate configured for a processing target to be mounted on a surface of the top plate; a heating part disposed on a back surface of the top plate or inside the top plate; a heat exchanger disposed adjacent to the top plate or the heating part, and including, in an interior of the heat exchanger, a circulation space in which a gas circulates; and a gas supply configured to supply the gas to the circulation space, wherein the heat exchanger includes: a projection group region including a plurality of projections composed of metal fiber and projecting in the circulation space, thereby promoting heat exchange with the gas; and a non-installation region free of the plurality of projections, thereby causing less heat exchange with the gas than in the projection group region.

### ADVANTAGEOUS EFFECTS OF THE INVENTION

According to one embodiment of the present invention, it is possible to efficiently control the temperature of a processing target and to promote uniformization of the in-plane temperature distribution in the processing target.

### BRIEF DESCRIPTION OF THE DRAWINGS

[FIG. 1] FIG. 1 is a schematic longitudinal cross-sectional view showing the configuration of an inspection device according to an embodiment.
[FIG. 2] FIG. 2 is an exploded oblique view showing the configuration of a mounting table.
[FIG. 3] FIG. 3 is a schematic longitudinal cross-sectional view showing the configuration of a mounting table.
[FIG. 4A] FIG. 4A is a schematic planar cross-sectional view showing an air circulation path in a circulation space.
[FIG. 4B] FIG. 4B is a schematic planar cross-sectional view showing an arrangement of a plurality of projections in a circulation space.
[FIG. 5] FIG. 5 is an enlarged side view showing the configuration of projections arranged in a circulation space.
[FIG. 6] FIG. 6 is a schematic longitudinal cross-sectional view showing the configuration of a stage according to a first modified example.
[FIG. 7] FIG. 7 is a schematic plan view showing a recessed container of a stage according to a second modified example.
[FIG. 8A] FIG. 8A is a schematic plan view showing a recessed container of a stage according to a third modified example.
[FIG. 8B] FIG. 8B is an oblique view of a heat insulating pipe.
[FIG. 9] FIG. 9 is a schematic plan view showing a part of a recessed container of a stage according to a fourth modified example.

### DETAILED DESCRIPTION OF THE INVENTION

Hereinafter, an embodiment for carrying out the present disclosure will be described with reference to the drawings. In the drawings, the same components are denoted by the same reference numerals, and redundant descriptions may be omitted.

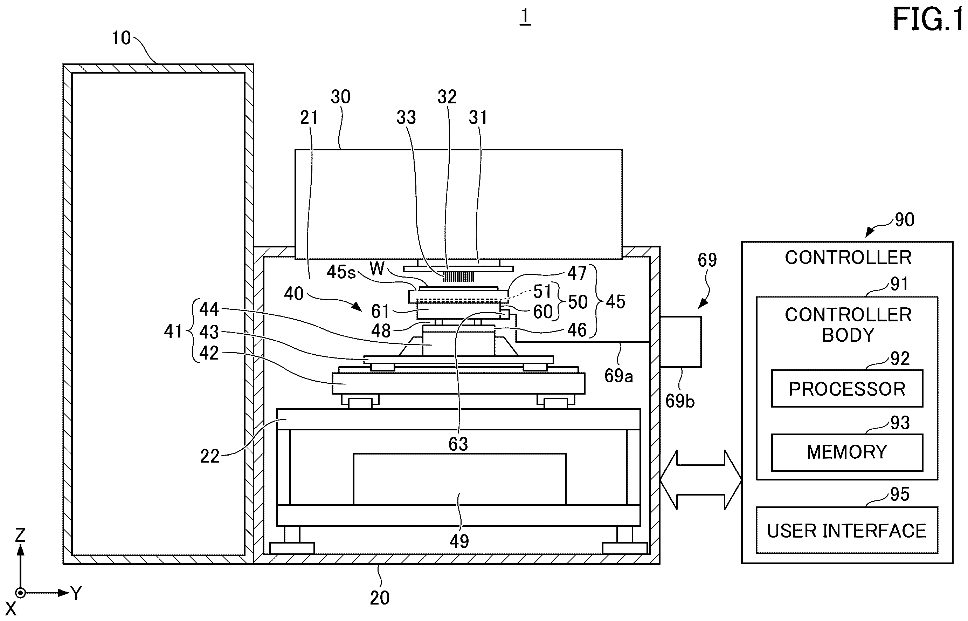

FIG. 1 is a schematic longitudinal cross-sectional view showing the configuration of an inspection device 1 according to an embodiment. As shown in FIG. 1, the inspection device 1 according to an embodiment performs electrical inspection of a wafer W, which is an example of a substrate. A plurality of semiconductor devices, which are inspection targets, are formed on the wafer W. The substrate is not limited to a wafer W, and may be a carrier, a glass substrate, a single chip, an electronic circuit board, and the like on which semiconductor devices are disposed.

The inspection device 1 includes a loader 10 for conveying the wafer W, a housing 20 disposed adjacent to the loader 10, a tester 30 disposed above the housing 20, a stage 40 housed in the housing 20, and a controller 90 for controlling each component of the inspection device 1.

The loader 10 takes out the wafer W from a Front Opening Unified Pod (FOUP) (not shown) and places it on the stage 40 moved in the housing 20. The loader 10 takes out an inspected wafer W from the stage 40 and stores it in the FOUP.

The housing 20 is formed in a substantially rectangular parallelepiped-box body, and includes in the interior of the housing 20, an inspection space 21 in which the wafer W is inspected. The stage 40 for conveying the wafer W is installed in the inspection space 21. The stage 40 moves in the inspection space 21 in three-dimensional directions (in the X-axis direction, Y-axis direction, and Z-axis direction) while holding the wafer W received from the loader 10 in the inspection space 21.

A probe card 32 is held in an upper part in the housing 20 via an interface 31. The interface 31 includes a performance board and a number of connection terminals (not shown), and is electrically connected to the tester 30. The tester 30 is connected to the controller 90 of the inspection device 1, and inspects the wafer W under a command from the controller 90.

The probe card 32 includes a plurality of probes 33 projecting downward in the inspection space 21. In an inspection performed by the inspection device 1, each probe 33 contacts a pad or a solder bump of a semiconductor device on the wafer W moved by the stage 40 to an appropriate three-dimensional coordinate position. In the state of each probe 33 being in this contact, the tester 30 electrically inspects each semiconductor device. After the inspection of each of a group of semiconductor devices, the controller 90 moves the stage 40 in the three-dimensional directions to shift the in-place position of the wafer W, and repeats the inspection of each semiconductor device of another group after another sequentially by the tester 30, thereby performing total inspection of the respective semiconductor devices.

The stage 40 includes a moving part 41 (an X-axis moving mechanism 42, a Y-axis moving mechanism 43, and a Z-axis moving mechanism 44) movable in the X-axis direction, the Y-axis direction, and the Z-axis direction, a mounting table 45, and a stage controller 49. The housing 20 includes a frame structure 22 for supporting the moving part 41 and the mounting table 45 of the stage 40 and the stage controller 49 on two tiers, i.e., the upper and lower tiers. The moving part 41 moves the mounting table 45 in the X-axis direction, the Y-axis direction, and the Z-axis direction based on power supply from the stage controller 49. In addition to moving the mounting table 45 in the X-axis direction, the Y-axis direction, and the Z-axis direction, the moving part 41 may be configured to rotate the mounting table 45 about an axis (θ direction).

The mounting table 45 has a mounting surface 45s having a true-circular planar shape on which the wafer W is directly mounted. Further, the mounting table 45 according to the present embodiment includes a temperature control mechanism 50 for controlling the temperature of the wafer W during inspection, thereby making the stage 40 function as a temperature control stage. Specifically, the mounting table 45 is configured by laminating a bottom plate 46, the temperature control mechanism 50 (a heat exchanger 60 and a heating part 51), and a top plate 47 in this order from the lower side to the upper side in the vertical direction.

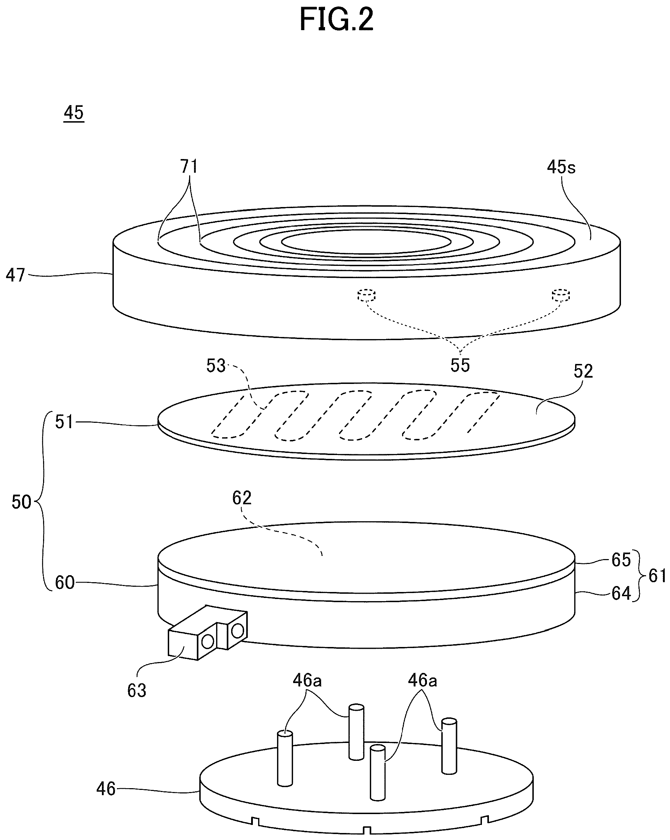

FIG. 2 is an exploded oblique view showing the configuration of the mounting table 45. As shown in FIG. 2, the bottom plate 46 is a member for attaching the mounting table 45 to the Z-axis moving mechanism 44. A plurality of fastening screws 46a for fastening the heat exchanger 60 are provided on the bottom plate 46 to project upward in the vertical direction. The plurality of fastening screws 46a support the heat exchanger 60, the heating part 51, and the top plate 47 with the heat exchanger 60 spaced from the bottom plate 46 such that a gap 48 (see FIG. 1) is formed between the bottom plate 46 and the heat exchanger 60. The gap 48 functions as a heat insulating part for blocking the temperatures of the heat exchanger 60 and the heating part 51 from affecting the moving part 41.

The heat exchanger 60 of the temperature control mechanism 50 includes a disk-shaped jacket 61 including in the interior of the jacket 61, a circulation space 62 in which air (gas) circulates, and a port 63 provided on the outer periphery of the jacket 61 for letting in and out gas into and out from the circulation space 62. The configuration of the heat exchanger 60 will be described later in detail.

The heating part 51 is formed by, for example, installing a heater 53 on the surface of a sheet-shaped heat diffusion plate 52, or in the sheet-shaped heat diffusion plate 52. The heat diffusion plate 52 is installed in parallel with the mounting surface 45s (in a horizontal direction). The heat diffusion plate 52 is composed of a material having an appropriate heat conduction efficiency (for example, polyimide, polyester, or ceramic), and diffusively conducts the temperature controlled by the heater 53 and the heat exchanger 60 to the top plate 47. In the present embodiment, polyimide is used for the heat diffusion plate 52, and the heating part 51 is a polyimide heater.

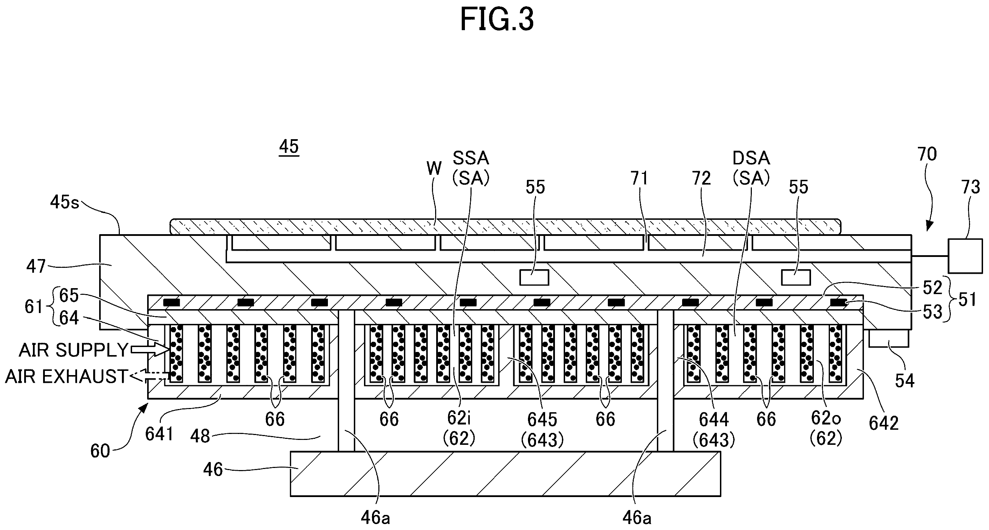

A well-known heating material, such as an electric heating wire, a heating pad, and the like, can be applied as the heater 53. The heater 53 is electrically connected to a thermostat 54 (see FIG. 3) installed on the top plate 47. Electric power supplied under the control of a temperature controller (not shown) of the stage controller 49 is supplied to the heater 53 through the thermostat 54. Thus, the heater 53 can heat substantially the entire surface of the heat diffusion plate 52 on or in which the heater 53 is installed. The mounting surface 45s may be divided into a plurality of regions, and the heater 53 may be configured to heat the plurality of regions individually.

The heating part 51 is fixed to the upper surface of the jacket 61 and to the lower surface of the top plate 47 by voidless jointing. This facilitates reduction of thermal resistance at the boundaries between the heat exchanger 60, the heating part 51, and the top plate 47.

FIG. 3 is a schematic longitudinal cross-sectional view showing the configuration of the mounting table 45. As shown in FIGS. 2 and 3, the top plate 47, which is a constituent component of the mounting table 45, is formed in a disk shape thicker than the heating part 51, and has the mounting surface 45s as the upper surface of the top plate 47 on which the wafer W is mounted. The top plate 47 includes a clamp mechanism 70 as a holder for holding the wafer W.

The clamp mechanism 70 includes a plurality of clamp openings 71 that are open to the mounting surface 45s, a suctioning flow path 72 provided inside the top plate 47 and communicating with the clamp openings 71, and a suctioning pump 73 communicating with the suctioning flow path 72 and provided at a predetermined position in the housing 20. Although the respective clamp openings 71 are groove-like in the illustrated example, they may be holes that are open to the mounting surface 45s. The suctioning flow path 72 is formed in an appropriate shape branching and extending in the top plate 47 in accordance with the positions of the respective clamp openings 71. The clamp mechanism 70 configured in this way clamps the wafer W to the mounting surface 45s by applying a clamp pressure (negative pressure) to the top plate 47 through the suctioning flow path 72 and the respective clamp openings 71 under the operation of the suctioning pump 73.

The thermostat 54 is installed on the lower surface of the top plate 47 that is on the side opposite to (on the back surface side of) the mounting surface 45s, and on the outer periphery of the top plate 47. That is, the temperature control mechanism 50 according to the present embodiment includes the thermostat 54 at a position that is on the outer side of the installation position of the heater 53 and is exposed to the inspection space 21. As a result, the temperature control mechanism 50 can prevent the thermostat 54 from being damaged due to deformation of the top plate 47 or the heating part 51 due to thermal impact.

Further, the top plate 47 includes a plurality of temperature sensors 55 for measuring the temperature of the mounting surface 45s (in other words, the temperature of the wafer W mounted on the mounting surface 45s) in the interior of the top plate 47 near the lower surface. The plurality of temperature sensors 55 are disposed, for example, in the center of the mounting surface 45s and near the outer periphery of the mounting surface 45s, and transmit temperatures detected at the respective locations to the controller 90. By including the plurality of temperature sensors 55, the stage 40 can sense the temperature distribution on the mounting surface 45s and improve the accuracy of temperature control by the temperature control mechanism 50. The type of each temperature sensor 55 is not particularly limited, and a thermistor or a thermocouple of a resistance temperature detector (RTD) type, an optical temperature sensor, a semiconductor temperature sensor, or the like may be applied.

Referring back to FIG. 1, the stage controller 49 is connected to the controller 90 and controls the operation of the stage 40 based on a command from the controller 90. The stage controller 49 includes, for example, a supervising controller for controlling the operation of the entirety of the stage 40, a PLC or a motor driver for controlling the operation of the moving part 41, a temperature controller for controlling the heating part 51 and the heat exchanger 60, a power source unit, and the like (none of which are shown).

The controller 90 includes a controller body 91 for controlling the entirety of the inspection device 1, and a user interface 95 connected to the controller body 91. The controller body 91 includes a computer, a control circuit board, and the like.

For example, the controller body 91 includes a processor 92, a memory 93, and an input/output interface and an electronic circuit (not shown). The processor 92 is one of, or a combination of a plurality of, a Central Processing Unit (CPU), a Graphics Processing Unit (GPU), an Application Specific Integrated Circuit (ASIC), a Field-Programmable Gate Array (FPGA), a circuit composed of a plurality of discrete semiconductors, and the like. The memory 93 is an appropriate combination of a volatile memory and a nonvolatile memory (for example, a compact disc, a digital versatile disc (DVD), a hard disk, a flash memory, and the like).

The user interface 95 may be a keyboard for a user to perform an operation for inputting a command and the like, or a display for visualizing and displaying the operating status of the inspection device 1. Alternatively, the user interface 95 may be such a device as a touch panel, a mouse, a microphone, a loudspeaker, and the like.

The controller 90 of the inspection device 1 inspects semiconductor devices on the wafer W by controlling the operation of the tester 30 while the probes 33 are in contact with the wafer W. The tester 30 transmits an electric signal from a test head (not shown) to the semiconductor devices on the wafer W, and receives a device signal, which is a response from the semiconductor device, thereby determining the presence or absence of an abnormality in each semiconductor device, and the like.

In the inspection of the wafer W, the controller 90 controls the temperature of the wafer W by operating the temperature control mechanism 50 such that the temperature becomes the target temperature suited to the recipe. For example, when the temperature range in which the operability of the semiconductor devices is guaranteed is 85°C, the temperature controller of the stage controller 49 heats the heating part 51 under a command from the controller 90 to raise the temperature of the wafer W to 85°C, which is the target temperature, via the top plate 47.

However, during the inspection of the wafer W, the wafer W generates heat due to power supply from the tester 30 to the wafer W. For example, when the amount of heat generation from the entire surface of the wafer W is 200 W, even if the heating of the heating part 51 is stopped before the inspection, the temperature of the wafer W might rise to 85°C or higher. Therefore, the inspection device 1 supplies air, which is a refrigerant, to the heat exchanger 60 under the control from the controller 90, thereby causing heat exchange with air in the heat exchanger 60 and lowering the temperature of the wafer W via the heating part 51 and the top plate 47. The inspection device 1 needs only to circulate gas for temperature control through the heat exchanger 60, and may supply an inert gas, such as nitrogen (N₂) and the like, to the heat exchanger 60 instead of air.

Next, the configuration of the heat exchanger 60 according to the present embodiment will be specifically described. As shown in FIGS. 2 and 3, the jacket 61 of the heat exchanger 60 is composed of a recessed container 64 and a cover 65, and the recessed container 64 and the cover 65 are joined with each other with an open part of the recessed container 64 covered with the cover 65, to form an integrated assembly. It is preferable that the recessed container 64 and the cover 65 are composed of a metal material having high heat conduction efficiency, such as copper and the like.

The recessed container 64 has a flat bottom wall 641 and a cylindrical outer wall 642 projecting vertically upward from the outer edge of the bottom wall 641. An inner space surrounded by the bottom wall 641 and the outer wall 642 is the circulation space 62 through which air circulates. The port 63 (see FIG. 2) is joined at a predetermined position of the outer wall 642 in the circumferential direction of the outer wall 642. The recessed container 64 has a plurality of inner walls 643 (a first inner wall 644 and a second inner wall 645) projecting from the bottom wall 641 on the inner side of the outer wall 642.

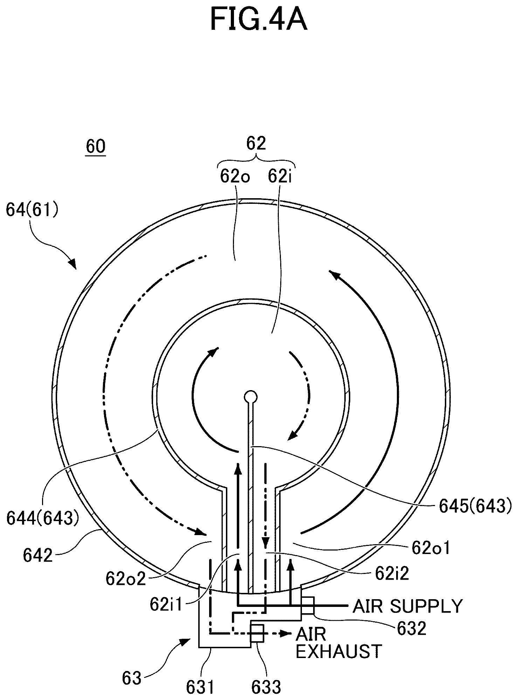

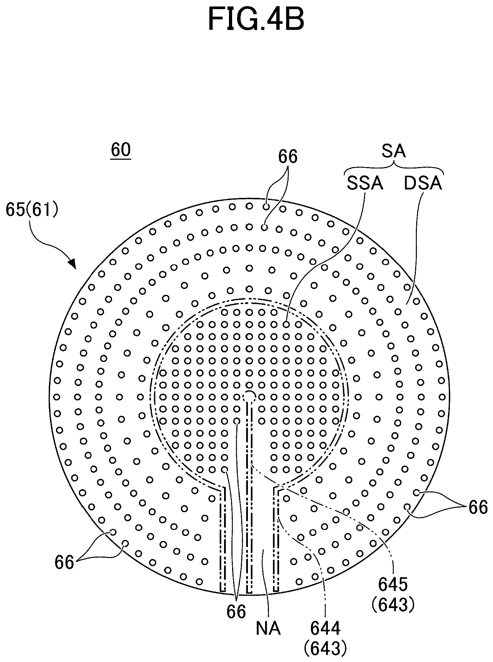

FIG. 4A is a schematic planar cross-sectional view showing a circulation path of air in the circulation space 62. FIG. 4B is a schematic planar cross-sectional view showing an arrangement of a plurality of projections 66 in the circulation space 62. As shown in FIG. 4A, the first inner wall 644 is a partition dividing the circulation space 62 into two spaces (an inner circulation space 62i and an outer circulation space 62o). The first inner wall 644 has a circular part having a diameter smaller than that of the outer wall 642 having a true-circular shape, and a rectangular part extending, at a position near the port 63, linearly toward the port 63 continuously from the circular part. The rectangular part of the first inner wall 644 constitutes an air inlet part and an air outlet part in the inner circulation space 62i, while the circular part of the first inner wall 644 constitutes an air circulation part in the inner circulation space 62i.

The second inner wall 645 is a partition forming the air inlet part and the air outlet part in the inner circulation space 62i. The second inner wall 645 extends linearly from the center of the circulation space 62 toward the port 63. Thus, the rectangular part of the first inner wall 644 and the second inner wall 645 form an inner air inlet path 62i1 and an inner air outlet path 62i2 in the inner circulation space 62i. The circular part of the first inner wall 644 and the second inner wall 645 extending to the center form an air path for annularly circulating air in the inner circulation space 62i.

Meanwhile, the outer circulation space 62o formed between the outer wall 642 and the first inner wall 644 circulates air annularly according to the circular shapes of the outer wall 642 and the first inner wall 644. An outer air inlet path 62o1 for introducing air from the port 63 into the outer circulation space 62o is formed on one lateral side of the rectangular part of the first inner wall 644. An outer air outlet path 62o2 for letting out air from the outer circulation space 62o to the port 63 is formed on the other lateral side of the rectangular part of the first inner wall 644.

The port 63 includes a port body 631, and a gas supply connector 632 and a gas exhaust connector 633 connected to the port body 631. The gas supply connector 632 is connected to a gas supply 69 provided on the outer side of the mounting table 45.

As shown in FIG. 1, the gas supply 69 includes a gas supply line 69a, one end of which is connected to the gas supply connector 632 (port 63), and a blower 69b connected to the other end of the gas supply line 69a. The gas supply line 69a is composed of a flexible tube, thereby supplying gas to the port 63 while allowing travel of the mounting table 45. For example, the blower 69b is provided outside the housing 20, and pressure-feeds air present outside the housing 20 to the heat exchanger 60 based on an operation command from the controller 90.

A flexible tube (not shown) is also connected to the gas exhaust connector 633, and the gas exhaust connector 633 can exhaust air that has circulated through the circulation space 62 to the outside of the housing 20. The inspection device 1 may be configured to let in and let out the air in the inspection space 21 in the housing 20 into and from the circulation space 62.

As shown in FIG. 4A, the port body 631 has a suitable introduction path (not shown) that guides air supplied from the gas supply connector 632 into the inner air inlet path 62i1 and into the outer air inlet path 62o1 by branching the air. Further, the port body 631 has a suitable introduction path (not shown) that guides the air let out through the inner air outlet path 62i2 and the outer air outlet path 62o2 to the gas exhaust connector 633 by merging the air.

Further, the port 63 circulates air such that the circulation direction of the air from letting into to letting out from the inner circulation space 62i and the circulation direction of the air from letting into to letting out from the outer circulation space 62o are opposite to each other. For example, in order to cause air to circulate clockwise in the inner circulation space 62i in FIG. 4A, the port 63 guides air to the left part in the rectangular part as the inner air inlet path 62i1, and guides the air to be let out through the right part in the rectangular part as the inner air outlet path 62i2. On the other hand, in order to cause air to circulate counterclockwise in the outer circulation space 62o of FIG. 4A, the port 63 guides air to the right side of the rectangular part as the outer air inlet path 62o1, and guides the air to be let out from (along?) the left side of the rectangular part as the outer air outlet path 62o2.

In this manner, with the port 63 and the recessed container 64 configured to let in and let out air dividedly into the two spaces (the inner circulation space 62i and the outer circulation space 62o), the heat exchanger 60 can facilitate uniformization of the in-plane temperature distribution in the wafer W. The heat exchanger 60 is not limited to the configuration in which the circulation space 62 is divided into two spaces, and may be a continuous space that is not divided, or may be divided into three or more spaces. The number and shape of the inner walls 643 may be appropriately set in accordance with the divisor, the shape, and the like of the circulation space 62.

Referring back to FIG. 3, the cover 65 of the jacket 61 covers the upper part of the recessed container 64, thereby tightly sealing the circulation space 62. The cover 65 has the plurality of projections 66 (fins) projecting downward in the vertical direction from the ceiling surface of the cover 65. The plurality of projections 66 are formed to be slightly shorter than the length by which the outer wall 642 and the inner walls 643 project, and hang down from the cover 65 toward the bottom wall 641. The projections 66 are arranged in the circulation space 62 to promote heat exchange with air circulating through the circulation space 62.

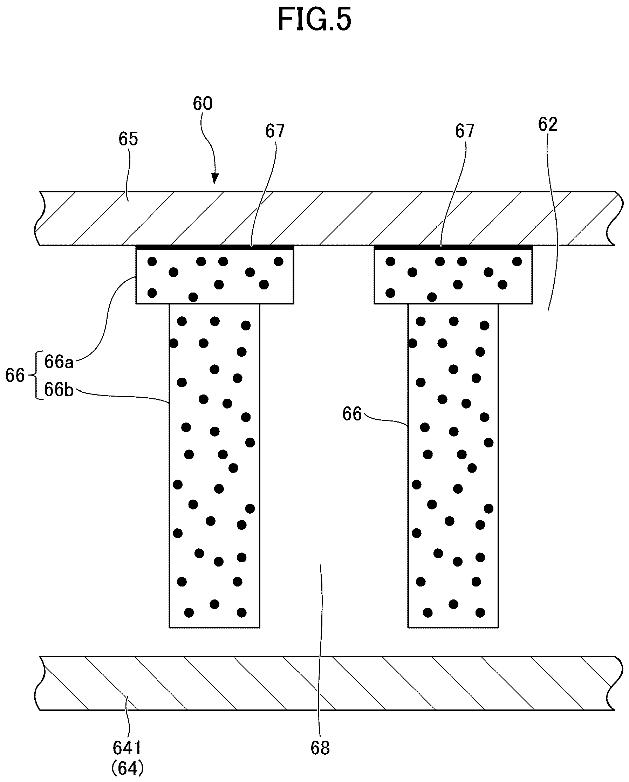

FIG. 5 is an enlarged side view showing the configuration of the projections 66 arranged in the circulation space 62. As shown in FIG. 5, each of the plurality of projections 66 is composed of a porous material formed by processing a nonwoven fabric of copper fibers (metal fibers) or a woven fabric of copper fibers (metal fibers) (copper paper). Therefore, the projections 66 include a large number of holes on the surface of, and in the interior of, the projections 66. As a result, the surface area of the projections 66 can be significantly increased, and the opportunity for the air circulating in the circulation space 62 to contact the fiber of the projections 66 can be increased.

In particular, as the projections 66 according to the present embodiment, a sintered body formed by fusing copper fibers by sintering is applied. For example, the projections 66 configured as a sintered body have a rod shape having an appropriate rigidity obtained by mutual fusing of the copper fibers through sintering of the copper fibers in an atmosphere of an appropriate gas (hydrogen gas or nitrogen gas). As a result, it is possible to fix the projections 66 to the cover 65 without deforming the projections 66.

The metal fibers forming the projections 66 may be composed only of metal fibers, or may be composed of a material other than the metal fibers (for example, thermally conductive particles, resins, and the like, such as alumina particles and the like) in addition to the metal fibers, or may be a bound product of the metal fibers. The average fiber diameter of the metal fibers may be, for example, in the range of 1 µm to 30 µm, and more preferably in the range of 2 µm to 20 µm. The lamination factor of the metal fibers in the projections 66 may be in the range of 5% to 70%, and more preferably in the range of 40% to 70%.

Specifically, as shown in FIG. 5, the projection 66 has a head part 66a fixed to the cover 65, and a body part 66b continuous from the head part 66a and projecting vertically downward by a length greater than that of the head part 66a. The head part 66a of the projection 66 is joined with the cover 65 via a joining part 67. As long as the joining part 67 can fix the projections 66 to the cover 65, well-known joining forms (welding, fusion, adhesion, and the like) may be employed. In particular, as the joining part 67, joining using silver nanoparticles is preferable. Thus, the thermal resistance between the cover 65 and the projections 66 is reduced, and the temperature of the cover 65 can be favorably conducted to each projection 66.

It is preferable that the length by which the projections 66 project from the cover 65 is designed to be 70% to 95% the height of the outer wall 642 and the inner walls 643. As a result, the projection ends of the projections 66 are positioned sufficiently close to the bottom wall 641 of the recessed container 64 and are separated from the bottom wall 641 as well. Therefore, the heat in the projections 66 that is temperature-controlled by the air is smoothly conducted to the cover 65 side instead of being directed to the bottom wall 641. Further, since the projections 66 and the bottom wall 641 are separated from each other, it is possible to prevent the projections 66 from coming into contact with the bottom wall 641 due to, for example, thermal expansion or thermal contraction, and to inhibit deformation of the projections 66. Therefore, the projection shape of the projections 66 can be maintained favorably, and variation in the air circulation resistance due to deformation of the projections 66 is inhibited. As the heat exchanger 60, a configuration in which the projections 66 are in contact with the bottom wall 641 may be employed.

As shown in FIG. 4B, the plurality of projections 66 are arranged to not interfere with the outer wall 642 and the inner walls 643 for the sake of assembly with the recessed container 64. The heat exchanger 60 according to the present embodiment includes: a projection group region SA that includes the plurality of projections 66, thereby promoting heat exchange with the air; and a non-installation region NA that are free of the plurality of projections 66, thereby causing less heat exchange with the air than in the projection group region SA.

The projection group region SA is a region in which the plurality of projections 66 are projected from the ceiling surface of the cover 65 with gaps (circulation gaps 68: see FIG. 5). The respective projections 66 may be arranged in a matrix or randomly in the projection group region SA. However, in a case where a location in the projection group region SA, at which the temperature would easily rise during an inspection of the wafer W, has been revealed, it is preferable to arrange a large number of projections 66 at that location. Specifically, the projection group region SA includes a dense region SSA in the inner circulation space 62i, in which the circulation gaps 68 between the plurality of projections 66 are narrow. Meanwhile, the projection group region SA includes a sparse region DSA in the outer circulation space 62o, in which the circulation gaps 68 between the plurality of projections 66 are wider than in the dense region SSA. For example, when using projections 66 having the same shape, it is preferable that the density of the projections 66 in the dense region SSA (the number of projections 66/cm²) is four to ten times that in the sparse region DSA. In the case of the structure shown in FIG. 4, the density is approximately five times higher. The distance between the projections 66 in the sparse region DSA is, for example, approximately 2 mm to 20 mm.

With the dense region SSA described above, the heat exchanger 60 can enhance the heat conduction efficiency of the projections 66 in the inner circulation space 62i, thereby promoting cooling of the center part of the wafer W, at which the temperature easily rises. On the other hand, due to the projections 66 arranged sparsely in the outer circulation space 62o, the heat exchanger 60 has a lower heat conduction efficiency in the outer circulation space 62o, but has an air circulation resistance in the outer circulation space 62o that is lower than the air circulation resistance in the inner circulation space 62i. The air circulates smoothly in the outer circulation space 62o, making it possible to uniformize the temperature distribution in the outer periphery of the wafer W. That is, with ease of adjusting the temperature of the entirety of the cover 65 having the projections 66 in accordance with the in-plane temperature distribution in the wafer W, the heat exchanger 60 can more uniformly lower the heat of the wafer W conducted via the top plate 47 and the heating part 51.

Further, the heat exchanger 60 includes the non-installation region NA, in which no plurality of projections 66 are arranged, in the inner air inlet path 62i1 and the inner air outlet path 62i2. The non-installation region NA may be regarded as a region in which the projections 66 are not arranged over equal to or greater than the distance (for example, 20 mm) between the respective projections 66 in the sparse region DSA. In the non-installation region NA, heat exchange with the air is significantly reduced due to the absence of the projections 66. Since the inlet/outlet part of the inner circulation space 62i, at which the temperature readily decreases, serves as the non-installation region NA and has a reduced heat conduction efficiency, it is possible to inhibit temperature decrease. Further, if the heat exchanger 60 is configured with less projections 66 arranged near the outer air inlet path 62o1 and the outer air outlet path 62o2 (the projection group region SA), temperature decrease near the air inlet/outlet part of the outer circulation space 62o can be further inhibited.

The inspection device 1 and the stage 40 (temperature control stage) according to the present embodiment are basically configured as described above, and their workings will be described below.

As shown in FIG. 1, under the control from the controller 90, the inspection device 1 moves the stage 40 on which the wafer W is mounted and brings the semiconductor devices on the wafer W into contact with the probes 33 of the probe card 32. After the probes 33 come in contact with the semiconductor devices, the tester 30 starts the inspection of the wafer F upon receiving a test command from the controller 90.

Before the start of the inspection (for example, when the wafer W is mounted on the mounting table 45 from the loader 10), the controller 90 of the inspection device 1 controls the operation of the temperature control mechanism 50 to control the temperature of the wafer W mounted on the mounting table 45. Here, the controller 90 instructs the target temperature of the inspection to the stage controller 49 (temperature controller), to control the heating part 51 and the heat exchanger 60 such that the target temperature is achieved. For example, the stage controller 49 controls the power supply to the heating part 51 to adjust the heating amount of the heater 53 while monitoring the temperatures detected by the temperature sensors 55.

When the temperature of the wafer W rises above the target temperature due to the power supply from the tester 30 to the wafer W during the inspection, the stage controller 49 operates the heat exchanger 60 to cool the wafer W. Here, the stage controller 49 rotates the blower 69b at an appropriate rotational speed based on the temperatures detected by the temperature sensors 55, and supplies air at an adjusted flow rate to the heat exchanger 60. As shown in FIG. 4A, this air is introduced into the inner air inlet path 62i1 and the outer air inlet path 62o1 of the heat exchanger 60 by being branched in the port 63.

The air introduced into the inner air inlet path 62i1 travels the inner air inlet path 62i1 straightly toward the center and circulates clockwise in the circular part of the inner circulation space 62i. Since the inner air inlet path 62i1 is the non-installation region NA in which the projections 66 are absent, it can move the air smoothly to the circular part while inhibiting the cover 65 from being cooled. Further, in the circular part of the inner circulation space 62i, the air comes into contact with the respective projections 66 in the dense region SSA and cools the respective projections 66. Therefore, the heat exchanger 60 can sufficiently cool the center part of the wafer W at which the degree of temperature rise via the top plate 47 and the heating part 51 is high. Then, when the air that has circulated through the circular part of the inner circulation space 62i moves to the inner air outlet path 62i2, which is the non-installation region NA, the air travels straight through the inner air outlet path 62i2 and is let out to the port 63.

On the other hand, the air introduced into the outer air inlet path 62o1 circulates counterclockwise from the outer air inlet path 62o1 through the annular outer circulation space 62o. In the outer circulation space 62o, the air contacts the projections 66 arranged in the sparse region DSA, to cool the projections 66. Therefore, the heat exchanger 60 can suitably cool the outer periphery of the wafer W at which the degree of temperature rise via the top plate 47 and the heating part 51 is low. Then, when the air that has circulated through the outer circulation space 62o moves to the outer air outlet path 62o2, the air is let out from the outer air outlet path 62o2 to the port 63.

Here, semiconductor devices, such as a 3D-NAND, a DRAM, and the like, have been experiencing year-by-year increase in the density, and the amount of heat generated from the wafer W has been increasing. As described above, the heat exchanger 60 according to the present embodiment effectively exchanges heat with the circulating air by means of the plurality of projections 66 composed of copper fibers and arranged in the circulation space 62 in which the air circulates. As a result, the temperature of the cover 65 to which the projections 66 are connected smoothly lowers to the air temperature (room temperature), and the temperatures of the heating part 51 planarly joined with the cover 65 and of the top plate 47 planarly joined with the heating part 51 are also lowered. As a result, the temperature control mechanism 50 can easily control the wafer W to the target temperature when the wafer W generates heat due to the inspection.

For example, a conventional stage is equipped with a chiller for cooling the wafer W, to thereby cool a liquid refrigerant while circulating the refrigerant. In contrast, the stage 40 according to the present embodiment can sufficiently lower the temperature of the wafer W by room-temperature air without using a chiller. By not using a chiller, the inspection device 1 can be greatly reduced in size, and can be easily installed without taking up much space at the installation site.

In addition, the heat exchanger 60 can promote uniformization of the in-plane temperature distribution in the wafer W in accordance with the arrangement form (the projection group region SA or the non-installation region NA) and the number (the dense region SSA or the sparse region DSA) of the projections 66. In particular, in the inspection of the wafer W, due to increase in heat generation, the in-plane temperature distribution in the wafer W is more likely to become nonuniform than before, and it is important to not simply set the projection group region SA, but to also set the non-installation region NA for inhibiting a large decrease in the temperature of the wafer W.

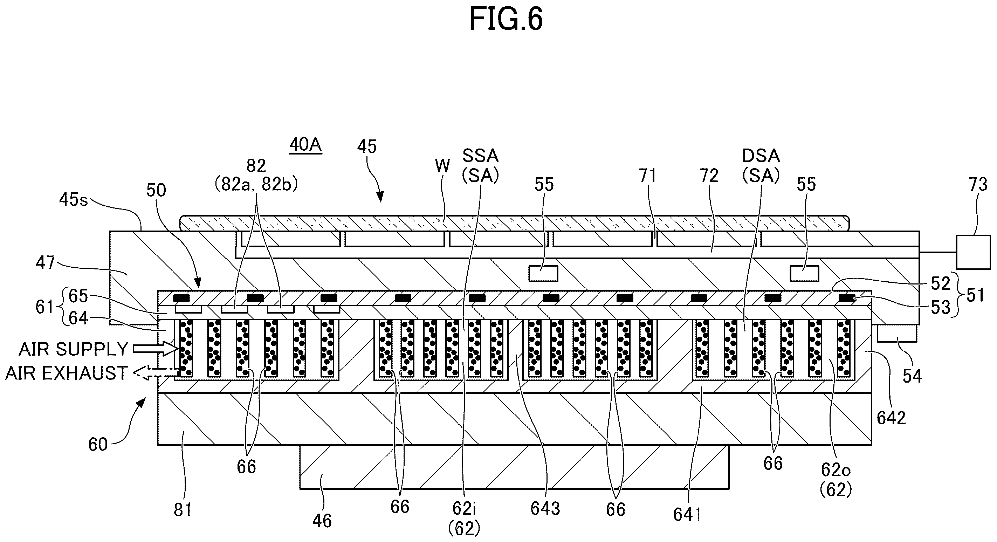

The inspection device 1 and the stage 40 according to the present disclosure are not limited to the embodiment described above, and various modified examples are applicable. For example, the shape of the plurality of projections 66 is not limited to a cylindrical shape having the head part 66a and the body part 66b, and can be any of various shapes, such as a prismatic shape, a plate piece shape, a cylindrical shape, a hemispherical shape, and the like. The shape of the circulation space 62 is also not limited to an annular shape, and may be any appropriate shape, such as a spiral shape, a meandering shape, and the like. Hereinafter, other modified examples of the stage 40 will be described with reference to FIGS. 6 to 9.

FIG. 6 is a schematic longitudinal cross-sectional view showing the configuration of a stage 40A according to a first modified example. The stage 40A according to the first modified example differs from the stage 40 in that a heat insulating plate 81 is laminated between the bottom plate 46 and the heat exchanger 60, and heat insulating parts 82 are provided in a part of the cover 65. The heat insulating plate 81 is composed of a material having a lower heat conduction efficiency than that of the jacket 61 of the heat exchanger 60 (for example, ceramic and the like), thereby providing heat insulation between the heat exchanger 60 and the bottom plate 46. In short, an appropriate heat insulator, such as the gap 48, the heat insulating plate 81, and the like, can be used between the bottom plate 46 and the heat exchanger 60.

The plurality of heat insulating parts 82 in the cover 65 are provided near the air inlet part (the inner air inlet path 62i1 and the outer air inlet path 62o1), which is a non-installation region NA, to inhibit a decrease in the temperature of the wafer W near there along with introduction of air. While the heat insulating parts 82 are hollow heat insulating spaces 82a in the illustrated example, a heat insulating member 82b composed of a material having a low heat conduction efficiency may otherwise be applied. For example, the heat insulating member 82b may be composed of a foamed body of resins, such as polystyrene, styrene, Styrofoam, polyethylene, polybutylene, polypropylene, polyester, polyurethane, melamine, acrylic, polycarbonate, and the like. In this way, also by applying the heat insulating parts 82 in the laminated structure from the circulation space 62 to the top plate 47 in the non-installation region NA, it is possible to effectively promote uniformization of the in-plane temperature distribution in the wafer W.

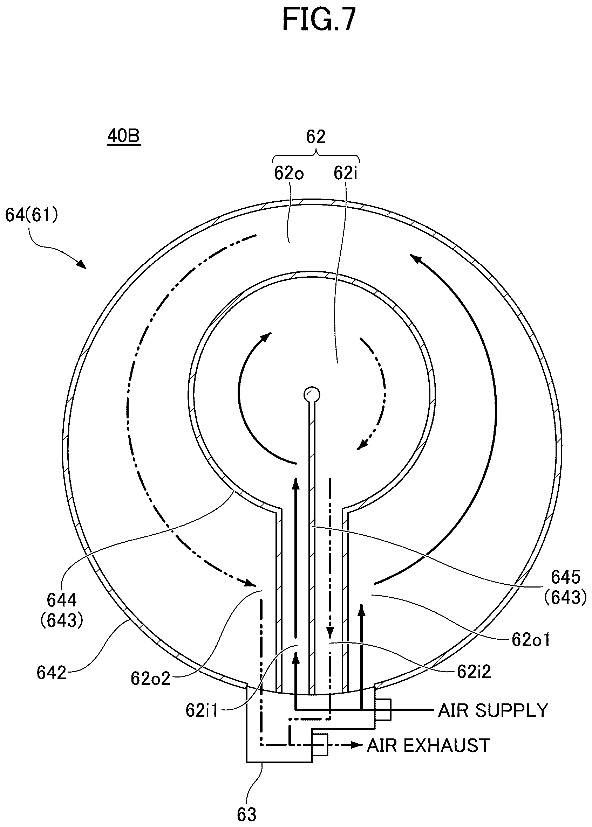

FIG. 7 is a schematic plan view showing the recessed container 64 of a stage 40B according to a second modified example. The stage 40B according to the second modified example differs from the stage 40 in that the cross-sectional area of the circulation path in the outer circulation space 62o is nonuniform by means of the shape of the inner walls 643. In this way, by varying the cross-sectional area of the circulation path in the outer circulation space 62o by means of the shape of the inner walls 643, it is possible to vary the flow velocity of air in the same circulation path. For example, by providing the circulation path near the outer air inlet path 62o1 with a large cross-sectional area to slow down the flow velocity of the air, it is possible to facilitate diffusion of the air into the outer circulation space 62o and to further uniformize the in-plane temperature distribution in the air inlet part.

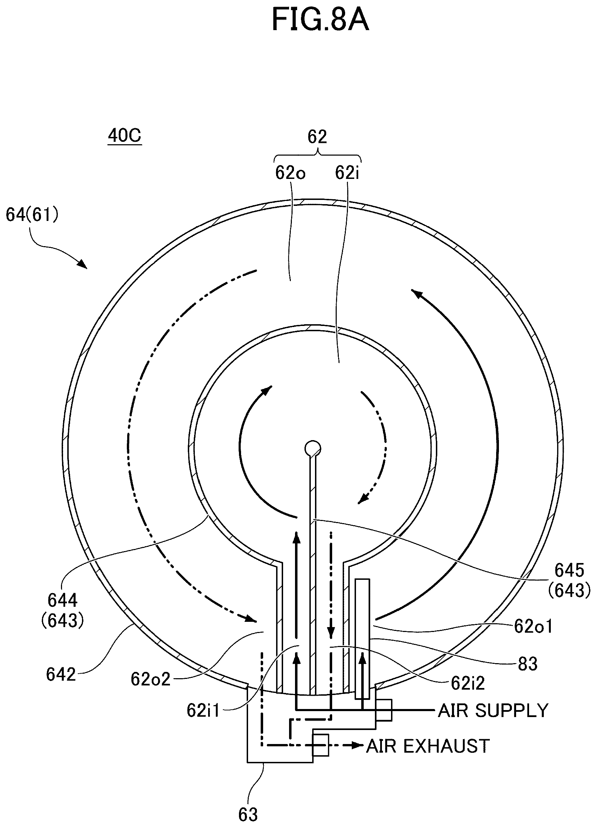

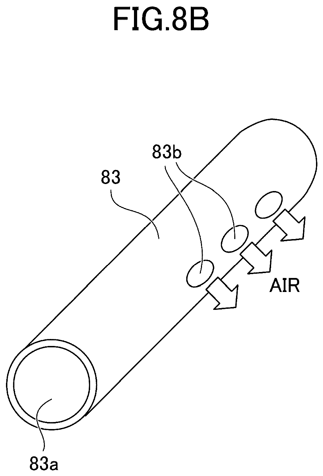

FIG. 8A is a schematic plan view showing the recessed container 64 of a stage 40C according to a third modified example. FIG. 8B is an oblique view of a heat insulating pipe 83. The stage 40C according to the third modified example differs from the stage 40 in that the heat insulating pipe 83 is disposed in the outer air inlet path 62o1 of the outer circulation space 62o, which is a non-installation region NA. The heat insulating pipe 83 is composed of a suitable heat insulating material having a lower heat conduction efficiency than that of the recessed container 64, and includes an air flow path 83a inside. Further, the heat insulating pipe 83 includes a plurality of discharge ports 83b communicating with the flow path 83a and configured to discharge air to the outer circulation space 62o on the outer peripheral surface of the heat insulating pipe 83 on the distal end side. The plurality of discharge ports 83b are arranged along the axial direction of the heat insulating pipe 83 and overlook the bottom wall 641 on their obliquely lower side, with the heat insulating pipe 83 joined with the recessed container 64.

When introducing air into the outer circulation space 62o, the stage 40C configured as described above can introduce air from the port 63 through the flow path 83a in the heat insulating pipe 83 and discharge the air obliquely downward from the plurality of discharge ports 83b. By applying the heat insulating pipe 83, it is possible to effectively thermally insulate the region around the outer air inlet path 62o1 where the temperature easily decreases along with introduction of the air, and to further promote uniformization of the in-plane temperature distribution in the wafer W.

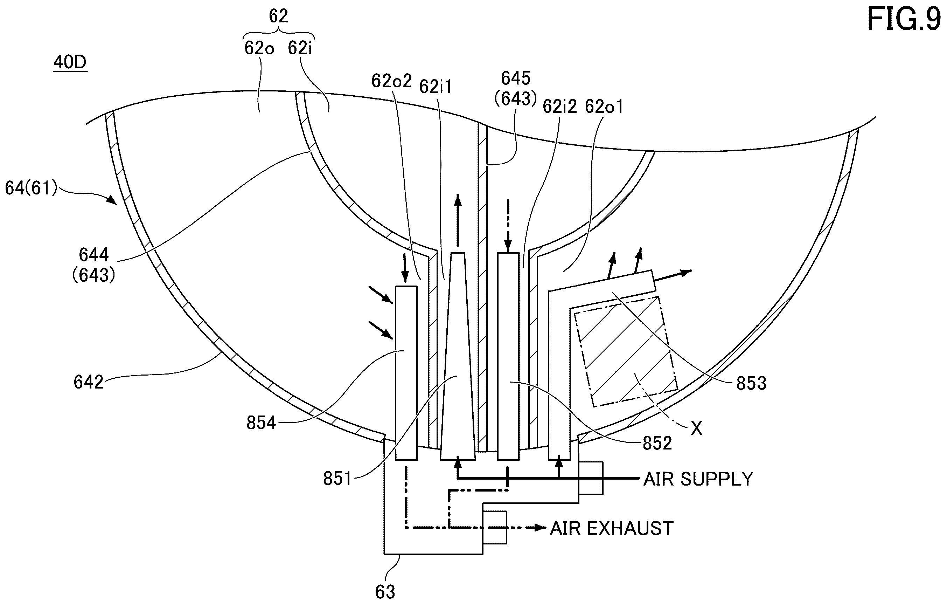

FIG. 9 is a schematic plan view showing a part of the recessed container 64 of a stage 40D according to a fourth modified example. The stage 40D according to the fourth modified example differs from the stage 40 in that a heat insulating pipe 85 is provided in each of the inner air inlet path 62i1, the inner air outlet path 62i2, the outer air inlet path 62o1, and the outer air outlet path 62o2, which are non-installation regions NA. By providing the plurality of heat insulating pipes 85 at the air inlet/outlet part of the circulation space 62, it is possible to more effectively inhibit temperature decrease at the inlet/outlet part.

The plurality of heat insulating pipes 85 are formed in different shapes depending on the installation locations. Specifically, the heat insulating pipe 851 installed in the inner air inlet path 62i1 is formed in a tapered shape tapering from the port 63 side toward the center. Thus, the heat insulating pipe 851 reduces the flow velocity of air on the port 63 side while increasing the flow velocity of air near the center. The heat insulating pipe 852 installed in the inner air outlet path 62i2 extends linearly toward the circular part without changes in the thickness. By configuring the air inlet/outlet part of the inner circulation space 62i in this manner, it is possible to inhibit heat transfer in the inlet/outlet part and promote uniformization of the in-plane temperature distribution in the wafer W.

On the other hand, the heat insulating pipe 853 installed in the outer air inlet path 62o1 extends linearly from the port 63 side and is then bent, and is provided with a plurality of discharge ports (not shown) for discharging air from an extending part of the pipe following the bent part counterclockwise in the outer circulation space 62o. Thus, while the heat insulating pipe 853 smoothly discharges air into the outer circulation space 62o, it can inhibit the flow of air into a region X surrounded by the heat insulating pipe 853 and the outer wall 642. Therefore, the heat insulating effect at the air inlet part can be enhanced. The heat insulating pipe 854 in the outer air outlet path 62o2 extends linearly, and is provided with a plurality of inflow ports (not shown) into which air that has circulated through the outer circulation space 62o flows. As a result, it is possible to inhibit stagnation of air in the outlet part of the outer circulation space 62o, and to promote uniformization of the in-plane temperature distribution in the wafer W.

Technical concepts and effects of the present disclosure explained in the above embodiments will be described below.

The temperature control stage (the stages 40, and 40A to 40D) according to a first aspect of the present invention includes: the top plate 47 configured for a processing target (wafer (W)) to be mounted on a surface of the top plate 47; the heating part 51 disposed on a back surface of the top plate 47 or inside the top plate 47; the heat exchanger 60 disposed adjacent to the top plate 47 or the heating part 51 and including, in the interior of the heat exchanger 60, the circulation space 62 in which a gas (air) circulates; and the gas supply 69 configured to supply a gas to the circulation space 62, wherein the heat exchanger 60 includes: the projection group region (SA) including the plurality of projections 66 composed of metal fibers and projecting in the circulation space 62, thereby promoting heat exchange with the gas; and the non-installation region (NA) free of the plurality of projections 66, thereby causing less heat exchange with the gas than in the projection group region (SA).

According to the above, the temperature control stage (the stages 40, an 40A to 40D) can stably exchange heat with gas by including the plurality of projections 66 composed of metal fibers in the circulation space 62 of the heat exchanger 60. Therefore, the temperature control stage can efficiently control the temperature of the processing target (wafer W) mounted on the top plate 47 based on the circulation of gas in the heat exchanger 60. In particular, since the heat exchanger 60 includes the projection group region SA and the non-installation region NA, it is possible to inhibit temperature decrease at the location where the temperature is low while proactively lowering the temperature of the location where the temperature is high, thereby promoting uniformization of the in-plane temperature distribution in the processing target.

Further, the non-installation region NA is provided in a part of the circulation space 62 via which the gas (air) is introduced into the circulation space 62. As a result, the temperature control stage (the stages 40, and 40A to 40D) can inhibit temperature decrease at the gas inlet part where the temperature easily decreases, and can further uniformize the in-plane temperature distribution in the processing target (wafer W).

Further, the projection group region SA includes the dense region SSA in which the gaps (the circulation gaps 68) between the plurality of projections 66 are narrow, and the sparse region DSA in which the gaps between the plurality of projections 66 are wider than in the dense region SSA. As a result, the temperature control stage (the stages 40, and 40A to 40D) can further promote heat exchange with the gas (air) in the dense region SSA, while inhibiting heat exchange with the gas in the sparse region DSA. As a result, the temperature control stage can further uniformize the in-plane temperature distribution in the processing target (wafer W).

Further, the circulation space 62 includes the inner circulation space 62i configured to cause the gas (air) to circulate in the center part of the heat exchanger 60, and the outer circulation space 62o configured to cause the gas to circulate outside the inner circulation space 62i, wherein the dense region SSA is provided in the inner circulation space 62i, and the sparse region DSA is provided in the outer circulation space 62o. As a result, the temperature control stage (the stages 40, and 40A and 40D) can proactively lower the temperature in the center part of the heat exchanger 60, while inhibiting temperature decrease in the outer periphery of the heat exchanger 60.

One of the inner circulation space 62i or the outer circulation space 62o causes the gas (air) to circulate clockwise, and the other causes the gas to circulate counterclockwise. As described above, the circulation directions of the gas in the inner circulation space 62i and the outer circulation space 62o are opposite to each other, thereby allowing heat exchange between opposite flows of the gas to be promoted. In particular, the circulation space 62 in which mutually opposite gas flows occur can effectively inhibit temperature decrease near the introduction of the gas, as compared with a configuration in which the circulation direction of the gas is uniform.

Further, the non-installation region NA includes the heat insulating member 82b configured to inhibit heat conduction in the laminated structure from the circulation space 62 to the top plate 47. By inhibiting heat conduction by means of the heat insulating member 82b in this way, the temperature control stage (the stage 40A) can effectively thermally insulate a region where the temperature would easily decrease, thereby uniformizing the in-plane temperature distribution in the processing target (wafer W).

Further, the non-installation region NA includes the heat insulating spaces 82a configured to inhibit heat conduction in the laminated structure from the circulation space 62 to the top plate 47. Also in this case, by means of the heat insulating spaces 82a, the temperature control stage (the stage 40A) can effectively thermally insulate a region where the temperature would easily decrease.

The non-installation region NA includes the heat insulating pipes 83 and 85 that are composed of ceramic or resin and through which gas (air) circulates. By using the heat insulating pipes 83 and 85 in this manner, the temperature control stage (the stages 40C and 40D) can smoothly move the gas to the intended position in the circulation space 62, while inhibiting the gas from going to a position where it is desired to inhibit heat exchange with the gas.

The thermostat 54 connected to the heating part 51 is provided at a position exposed to the outside from the top plate 47 or the heat exchanger 60. By disposing the thermostat 54 connected to the heating part 51 in the exposed state in this manner, the temperature control stage (the stages 40, and 40A to 40D) can avoid damage to the thermostat 54 caused by deformation due to thermal impact from the heating part 51 and the heat exchanger 60.

The heating part 51 is formed by installing a polyimide heater (the heater 53) in the heat diffusion plate 52 configured to diffuse heat. By applying the polyimide heater to the heat diffusion plate 52 in this manner, it is possible to make the heating part 51 as thin as possible in the temperature control stage (the stages 40, and 40A to 40D), and to allow smoother heat conduction between the top plate 47 and the heat exchanger 60.

A second aspect of the present disclosure is the inspection device 1 including: the temperature control stage (the stages 40, and 40A to 40D) on which a substrate (wafer W) is mounted; and the tester 30 configured to electrically inspect the substrate mounted on the temperature control stage, wherein the temperature control stage includes: the top plate 47 configured for the substrate to be mounted on a surface of the top plate 47; the heating part 51 disposed on the back surface of the top plate 47 or inside the top plate 47; the heat exchanger 60 disposed adjacent to the top plate 47 or the heating part 51 and including, in the interior of the heat exchanger 60, the circulation space 62 in which a gas (air) circulates; and the gas supply 69 configured to supply the gas to the circulation space 62, wherein the heat exchanger 60 includes: the projection group region (SA) including the plurality of projections 66 composed of metal fibers and projecting in the circulation space 62, thereby promoting heat exchange with the gas; and the non-installation region (NA) free of the plurality of projections 66, thereby causing less heat exchange with the gas than in the projection group region (SA). Also in this case, the inspection device 1 can efficiently control the temperature of the substrate (wafer W) and promote uniformization of the in-plane temperature distribution in the substrate.

The inspection device 1 and the temperature control stage (the stages 40, and 40A to 40D) according to the embodiments disclosed herein are exemplary and non-limiting in all respects. The embodiments can be modified and improved in various forms without departure from the scope and spirit of the appended claims. The particulars described in the above-described embodiments can be configured in other ways to the extent to which no contradiction would be involved, and can be combined to the extent to which no contradiction would be involved.

The temperature control stage of the present disclosure may be applied to devices that perform substrate processing, and can be applied to, for example, Atomic Layer Deposition (ALD) devices, and any type among Capacitively Coupled Plasma (CCP), Inductively Coupled Plasma (ICP), Radial Line Slot Antenna (RLSA), Electron Cyclotron Resonance Plasma (ECR), and Helicon Wave Plasma (HWP) devices.

The present application claims the priority to Japanese Patent Application No. 2023-177700, filed on October 13, 2023, which is hereby incorporated by reference in its entirety.

### REFERENCE SIGNS LIST

- 1: inspection device
- 30: tester
- 40, 40A to 40D: stage
- 47: top plate
- 51: heating part
- 60: heat exchanger
- 62: circulation space
- 66: projection
- 69: gas supply
- NA: non-installation region
- SA: projection group region
- W: wafer

## Claims

1. A temperature control stage, comprising:
a top plate configured for a processing target to be mounted on a surface of the top plate;
a heating part disposed on a back surface of the top plate or inside the top plate;
a heat exchanger disposed adjacent to the top plate or the heating part, and including, in an interior of the heat exchanger, a circulation space in which a gas circulates; and
a gas supply configured to supply the gas to the circulation space,
wherein the heat exchanger includes: a projection group region including a plurality of projections composed of metal fiber and projecting in the circulation space, thereby promoting heat exchange with the gas; and a non-installation region free of the plurality of projections, thereby causing less heat exchange with the gas than in the projection group region.

2. The temperature control stage according to claim 1,
wherein the non-installation region is provided in a part of the circulation space via which the gas is introduced into the circulation space.

3. The temperature control stage according to claim 1 or 2,
wherein the projection group region includes a dense region in which a gap between the plurality of projections is narrow, and a sparse region in which a gap between the plurality of projections is wider than in the dense region.

4. The temperature control stage according to claim 3,
wherein the circulation space includes an inner circulation space configured to cause the gas to circulate in a center part of the heat exchanger, and an outer circulation space configured to cause the gas to circulate outside the inner circulation space,
the dense region is provided in the inner circulation space, and
the sparse region is provided in the outer circulation space.

5. The temperature control stage according to claim 4,
wherein one of the inner circulation space or the outer circulation space causes the gas to circulate clockwise, and the other causes the gas to circulate counterclockwise.

6. The temperature control stage according to claim 1 or 2,
wherein the non-installation region includes a heat insulating member configured to inhibit heat conduction in a laminated structure from the circulation space to the top plate.

7. The temperature control stage according to claim 1 or 2,
wherein the non-installation region includes a heat insulating space configured to inhibit heat conduction in a laminated structure from the circulation space to the top plate.

8. The temperature control stage according to claim 1 or 2,
wherein the non-installation region includes a heat insulating pipe that is composed of ceramic or resin and through which the gas circulates.

9. The temperature control stage according to claim 1 or 2, further comprising:
a thermostat connected to the heating part, the thermostat being at a position exposed to outside from the top plate or the heat exchanger.

10. The temperature control stage according to claim 1 or 2,
wherein the heating part is composed of a heat diffusion plate configured to diffuse heat, and a polyimide heater installed on or in the heat diffusion plate.

11. An inspection device, comprising:
a temperature control stage on which a substrate is mounted; and
a tester configured to electrically inspect the substrate mounted on the temperature control stage,
wherein the temperature control stage includes:
a top plate configured for the substrate to be mounted on a surface of the top plate;
a heating part disposed on a back surface of the top plate or inside the top plate;
a heat exchanger disposed adjacent to the top plate or the heating part, and including, in an interior of the heat exchanger, a circulation space in which a gas circulates; and
a gas supply configured to supply the gas to the circulation space, and
wherein the heat exchanger includes: a projection group region including a plurality of projections composed of metal fiber and projecting in the circulation space, thereby promoting heat exchange with the gas; and a non-installation region free of the plurality of projections, thereby causing less heat exchange with the gas than in the projection group region.
